# EUROPEAN PATENT SPECIFICATION

(11) **EP 0 828 296 B1**
(45) Date of publication and mention of the grant of the patent: **01.06.2005**
(21) Application number: 97305987.6
(22) Date of filing: 06.08.1997
(51) Int. Cl.: H01L 29/165, H01L 39/00

(54) **High temperature superconductivity in strained Si/SiGe**
Hochtemperatur-Supraleitfähigkeit in einem gespannten Si/SiGe-Übergang
Supraconductivité à haute température dans une jonction contrainte Si/SiGe

(30) Priority: 03.09.1996 US 707348
(43) Date of publication of application: 11.03.1998
(73) Proprietor: International Business Machines Corporation, Armonk, N.Y. 10504 (US)
(72) Inventor: Chu, Jack Oon, Astoria, New York 11103 (US); Ismail, Khalid EzzEldin, White Plains,New York 10603 (US); Lee, Kim Yang, Mount Kisco, New York 10549 (US)
(74) Representative: Boyce, Conor

(56) References cited:
- EP-A- 0 494 395
- EP-A- 0 683 522
- PATENT ABSTRACTS OF JAPAN vol. 12, no. 200 (E-619), 9 June 1988 & JP 63 000173 A (FUJITSU LTD), 5 January 1988,
- PATENT ABSTRACTS OF JAPAN vol. 12, no. 215 (E-623), 18 June 1988 & JP 63 009983 A (FUJITSU LTD), 16 January 1988,
- BUMAI YU A ET AL: "Possible realization of high-temperature superconductivity in semiconductors" SOVIET JOURNAL OF LOW TEMPERATURE PHYSICS, vol. 16, no. 6, June 1990, NEW YORK US, pages 417-419, XP002051601
- Y.E. LOZOVIK ET AL.: "A new mechanism for superconductivity : pairing between spatially separated electrons and holes" SOVIET PHYSICS JETP., vol. 44, no. 2, August 1976, NEW YORK US, pages 389-397, XP002051602

## Description

The present invention is directed to a high temperature superconducting semiconductor structure, and more particularly, to a semiconductor structure having strained Si/SiGe layers separated by a thin SiGe barrier layer.

Superconductors are of great interest for dissipationless transmission and for use in magnetic detectors, among others. Several drawbacks prevent wide use of superconductors, such as the need for excessively low temperatures and incompatibility with standard silicon (Si) technology. Conventional superconductors require low temperature in order to become superconducting, which makes their commercial use quite limited.

Advances in superconductivity have been due to improved electron mobility/conductivity by applying superlattices or strained layers. However, satisfactory superconductors that operate at relatively high temperature, and are compatible with silicon technology have not been achieved. Thus, although high temperature superconductors have been realized, such conventional high temperature superconductors are not fully compatible with standard Si technology, which is the main driver of the semiconductor industry.

JP63000173 discloses a high speed semiconductor device. When an insulating AlA thin-layer is interposed between GaAs layers and an N-type impurity is introduced to a section in the vicinity of the interface and a P-type impurity to a section in the vicinity of the interface through planar doping respectively to shape an electron layer or a hole layer, superconductivity is acquired at a low temperature by an electron-hole pair superconducting mechanism.

JP63009983 discloses the facilitation of superconduction by removing the local storage of the hole of a transistor using the superconductive mechanism of the pair of an electron and the hole by taking a hole current (an electron current when the hole current is taken) by a selective electrode and by short-circuiting.

USA4860067 discloses a semiconductor heterostructure comprising an epitaxial undoped 1 micron layer of GaAs.

EPA0683522 discloses a method and a layered planar heterostructure comprising one of or both n and p-channel field effect transistors, incorporating a plurality of semiconductor layers on a semiconductor substrate wherein one layer is silicon or silicon germanium under tensile strain and one layer is silicon germanium under compressive strain.

EPA0494395 discloses a MISFET having a graded semiconductor alloy channel layer of silicon germanium.

Therefore, there is a need for high temperature superconductors that are compatible with conventional Si technology.

The object of the present invention is to provide a superconducting semiconductor structure that eliminates the problems of conventional superconductors.

Another object of the present invention is to provide a structure that is superconducting at relatively high temperatures.

Yet another object of the present invention is to provide a high temperature superconducting structure that is compatible with conventional silicon technology.

A further object of the present invention is to provide a superconducting structure, where the superconductivity is induced by light.

An additional object of the present invention is to provide a gated superconducting structure in which the superconductive state is achieved or destroyed by changing the ratio of electrons to holes by varying gate voltages.

These and other objects of the present invention as claimed in claim 1 are achieved by a structure for carrying superconducting current comprising a substrate; a first epitaxial P type semiconductor layer for transporting holes; a second epitaxial barrier layer positioned on said first layer, said barrier layer restricting the recombination of electrons while permitting coulomb force attraction between electrons and said holes to form electron-hole pairs; and a third epitaxial N type semiconductor layer for transporting said electrons; characterised in that said first layer includes SiGe and wherein said first layer is under compressive strain; and wherein said third layer includes Si and wherein said third layer is under tensile strain.

The barrier layer restricts recombination of electrons and holes, while permitting coulomb force attraction between the electrons and holes to form electron-hole pairs. The formation of electron-hole pairs is enhanced due to the small thickness of the barrier layer, which may have a thickness of approximately 5 A to 30 A (10 Å =1 nm) for example.

The inventive structure is based on strained Si/SiGe interface that has high temperature super-conductivity. The first layer includes SiGe, such as Si₁₋ₓGeₓ, where x is in the range of approximately 0.6 to approximately 0.8. The second layer also includes SiGe, such as Si₁₋ₓGeₓ, where x is in the range of about 0.3 to about 0:4. The third layer includes Si. Illustratively, the first layer is under compressive strain, and the third layer is under tensile strain.

The layers are fully compatible with conventional structures for Si/SiGe CMOS. Thus, CMOS structures may be combined with the inventive structure, which acts as superconducting interconnects. In the inventive structure, adjacent layers of si and SiGe are grown, such that electrons 30 exist in the Si layer, and holes exist in the SiGe layers without recombining. Current is fed through the third layer, which is a Si channel, with electrons in it, and returned in an opposite direction through the first layer, which is a SiGe channel containing holes. Electrons and holes can be introduced by doping, modulation-doping, 35 optically or using a field-effect from a top and/or bottom gate. This allows electrons and holes to move in the same direction, and due to the coulomb attraction, drag each other to form a superfluid. The inventive structure also includes electrical connections.

The present invention achieves high temperature superconductivity due to electron and hole pairing in the same structure without recombining. Superconductivity in the inventive structure results from electron-hole drag in the strained Si/SiGe layered structure. It is believed that conductivity of the inventive structure is sufficiently enhanced to produce superconductivity at temperature higher than would otherwise be possible in semiconductor materials.

Superconductivity is induced when equal densities of electrons and holes exist in adjacent channels. when the ratio of electron to hole densities is changed from equality, superconductivity is destroyed.

An embodiment of the invention will now be described with reference to the accompanying drawings, in which:
FIG 1 shows a cross-section of a high temperature superconductivity structure having adjacent electron and hole channels according to the present invention;
FIG 2 shows a test structure for flowing current and measuring longitudinal and transverse magneto-resistance according to the present invention;
FIG 3 is a graph showing a nearly instantaneous large increase in current when the superconductor structure of FIG 1 turns on according to the present invention; and
FIG 4 is a graph showing nearly instantaneous large increases in currents when the superconductor structure of FIG 1 turns on as a function of top and bottom gate biases according to the present invention.

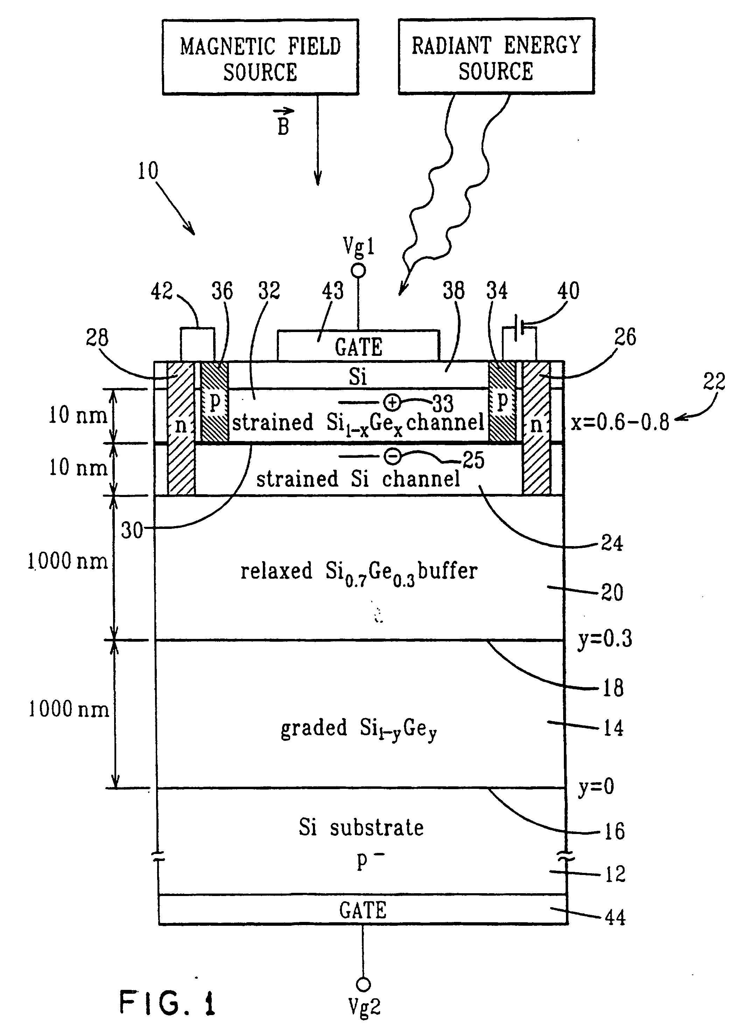

FIG 1 shows a cross-section of a high temperature superconducting structure 10, according to one embodiment of the present invention. The structure 10 carries superconducting currents and includes a substrate 12. Illustratively, the substrate 12 is silicon (Si), which is doped p-.

A layer of silicon Germanium (SiGe) 14 is formed over the substrate 12. This Si_{1-y}Geₓ layer 14 is graded, where y=0 at the interface 16 between the substrate 12 and the graded layer 14. At an opposite interface 18, i.e., opposite from the substrate-to-graded layer interface 16, the value of y is 0.3, for example.

A relaxed SiGe layer 20, such as an Si_{0.7}Ge_{0.3} layer is formed over the graded layer 14. The relaxed layer 20 acts as a buffer layer. Illustratively, the graded and relaxed layers 14, 20 are each approximately 1000 nm thick.

A high temperature superconducting channel 22 is formed over the relaxed buffer layer 20. The superconducting channel 22 includes three epitaxial layers, namely, two semiconductor layers doped with different type dopants, separated by a barrier layer. Illustratively, a silicon channel 24 is formed over the buffer layer 20 having a thickness of approximately 10 nm. The silicon channel 24 is used to transport electrons 25. A pair of contacts 26, 28, which are silicon doped with N-type material for example, are formed at both edges of the silicon channel 24. The silicon channel 24 is under a tensile strain because the underlying substrate is a relaxed SiGe buffer. This is advantageous because the silicon under tensile strain of the Si channel 24 forms an electron quantum well, which confines the electrons.

A thin barrier layer 30 is formed over the silicon channel 24. The barrier layer includes Si₁₋ₓGeₓ, where x is in the range from about 0.3 to about 0.4.

Next, an Si₁₋ₓGeₓ layer 32 is formed over the barrier layer 30, and is used to transports holes 33. Illustratively, the P-type channel 32 has a thickness of approximately 10 nm, and x is in the range from about 0.6 to about 0.8. The SiGe P-type channel 32 is under a compressive strain because the underlying substrate is a relaxed SiGe buffer layer 20 with lower Ge-content. This is advantageous because the high Ge-channel 32 forms a hole quantum well, which confines the holes. The Si and SiGe channels 24, 32 are referred to as type II (staggered) aligned layers.

The P and N type channels 32, 24 may be inverted, where the P-type channel 32 is formed over the relaxed SiGe buffer layer 20, and the N-type channel 24 is formed over the thin barrier layer 30.

The barrier layer 30 is thick enough to restrict recombination of electrons 25 and holes 33 flowing in the N and P channels 24, 32, respectively, yet thin enough to allow coulomb force attraction between these electrons 25 and holes 32 to form electron-hole pairs. Illustratively the thickness of the barrier layer is from approximately 5 Å to approximately 30 Å.

A pair of P-type regions 34, 36, acting as P-type electrodes or contacts, is formed at the edges of the P-type channel 32. A top silicon layer 38 is formed over the P-type channel 32.

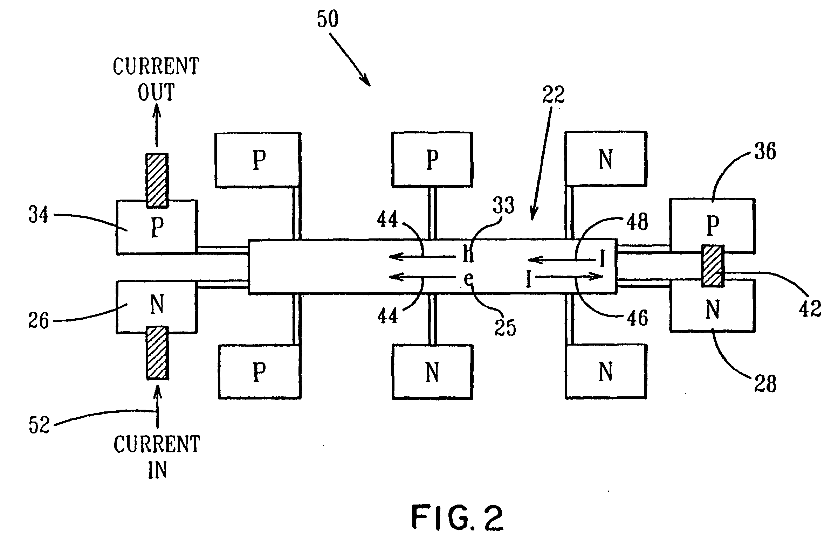

A DC bias in applied to the P and N contacts 34, 26 on one side of the channel 22, for example, using a battery 40. The P and N contacts 36, 28 located opposite the biased contacts 34, 26 are shorted together by a wire 42. These connections cause current to flow through the channel 22 as discussed in connection with FIG 2.

In accordance with the present inventions, the electron-hole pairing in the inventive structure 10, which is implemented with the Si/SiGe channels 24, 32, results in superconductivity. Superconductivity is induced when equal densities of electrons 25 and holes 33 exist in the adjacent channels 24, 32. when the ratio of electron to hole densities is changed from equality, superconductivity is destroyed. The inventive structure 10 achieves superconductivity in single crystal material that is fully compatible with semiconductor manufacturing and, in particular, with a recently suggested Si/SiGe CMOS process discussed in the following reference:
(1) U.S. patent number 5,534,713, issued on July 9, 1996, to Khalid Ismail and Frank Stern,entitled "CMOS Transistor Logic Strained Si/Ge Heterostructure Layers", and assigned to the same assignee hereof. The idea of electron-hole pairing, and the possibility of forming a superfluid has been generally suggested in the following reference:
(2) Yu.E. Lozovik and V.I. Yudson, "A New Mechanism for Superconductivity: Pairing Between Spatially Separated Electrons and Holes", Sov. Phys. JETP, vol 44, No. 2, pp. 389-397 (1976).

The essential requirements for forming such a superfluid is the following: (1) that the electrons and holes have similar masses and concentrations; (2) that they can co-exist without recombining; (3) that they are close enough for the coulomb interaction between them to be significant; (4) and that they move in the same directions, so that the currents in the N and P channels 24, 32 flow in opposite directions.

The strained Si/SiGe channels 24, 32 of the superconducting structure 10 are grown in such a way that electrons 25 are confined in the Si layer 24, and holes 33 are confined in the SiGe layer 32. The strain causes the electron and hole masses in the plane perpendicular to the growth axis to be different from their masses perpendicular to the plane along the growth axis. In the structure for CMOS discussed in the Ismail reference (1) cited above, the effective electron mass in the plane is 0.2 me, and perpendicular to the plane is 0.96 me, where me is the electron mass. For holes 33,the corresponding masses are 0.15 me and 0.5 me, respectively.

The inventive superconducting structure 10 has great advantages over conventional superconducting structures to implement the electron-hole pairing structure. First, the type-two (staggered) band alignment of Si and SiGe layers 24, 32 makes it possible to confine and spatially separate the electrons 25 and holes 33. Second, the high perpendicular masses of electrons and holes facilitates separation of wave functions of both particles (i.e., electrons 25, and holes 33) by the very thin barrier 30.

In conventional material systems, which exhibit type-two band alignment, such as InAs/GaSb, the electron mass is very small, and hence a thick barrier is required. It is very advantageous to have a thin barrier in order to increase the coulomb attraction between the electrons and holes to form pairs. In the Si/SiGe channels 24, 32, the in-plane masses and mobilities of both electrons 25 and holes 33 are quite similar, which helps in forming a superfluid state. The inventive structure 10 is grown on Si substrates and is compatible with the recently suggested CMOS process discussed in the Ismail reference (1), and with conventional semiconductor manufacturing.

As shown in FIG 2, in order to form electron-hole pairs, the electrons 25 and holes 33 have to be moving in the same direction shown by arrow 48. Two currents flow in opposite directions as shown by arrows 46, 48.

Fig 2 is a test pattern or structure 50 for examining electron-hole drag, where current 52 flows into the N-type contact 26, through the channel 22 in direction 46 toward the N-type contact 28, to the P-type contact 36 through the wire 42, back through the channel 22 in direction 48 toward the P-type contact 34, and out of the P-type contact 34. The current flows in direction 46 in the lower part of the channel 22, corresponding to the N-type channel 24 of FIG 1, because the electrons 25 flow in a direction which is opposite to the current direction 46. Similarly, the current flows in direction 48 in the upper part of the channel 22, corresponding to the P-type channel 32 of FIG 1, because the holes 33 flow in the same direction as the current direction 48.

The test structure 50 is used for flowing currents and measuring longitudinal and transverse magneto-resistance of the electron and hole channels. The electrons and holes are forced to flow in the same direction, e.g., from contacts 28, 36 to contacts 26, 34. The test structure 50 is used as follows. A positive voltage is applied to the N-contact 26, contacts 28 and 36 are shorted together by the wire 42, and the P-contact 34 is grounded.

The occupation of the channels 24, 32 with electrons 25 and holes 33 can be induced by shining light on the sample, on the top silicon layer 38, with a wavelength that is in the range of approximately 1.0 µm to approximately 1.5 µm. This wavelength corresponds to the bandgap of the strained alloy SiGe in layer 32. The carrier density can also be controlled using a top gate 43 or a bottom gate 44 bias. Thus, the inventive device 10 can also be operated as a transistor in a three/four terminal configuration. In the three terminal configuration, P and N contacts 36, 28 are shorted together, while in the four terminal configuration, the four terminals are the four contacts 26, 34, 28, 36. The inventive device can be switched from a low conductivity state to a superconducting state while the supply bias 40 can be very low.

The inventive device can be used as an interconnect in circuits and in building Josephson junction devices and circuits, and in magnetic detectors. It can be also used as a very efficient photo-detector in the infrared, and for low power field-effect transistors.

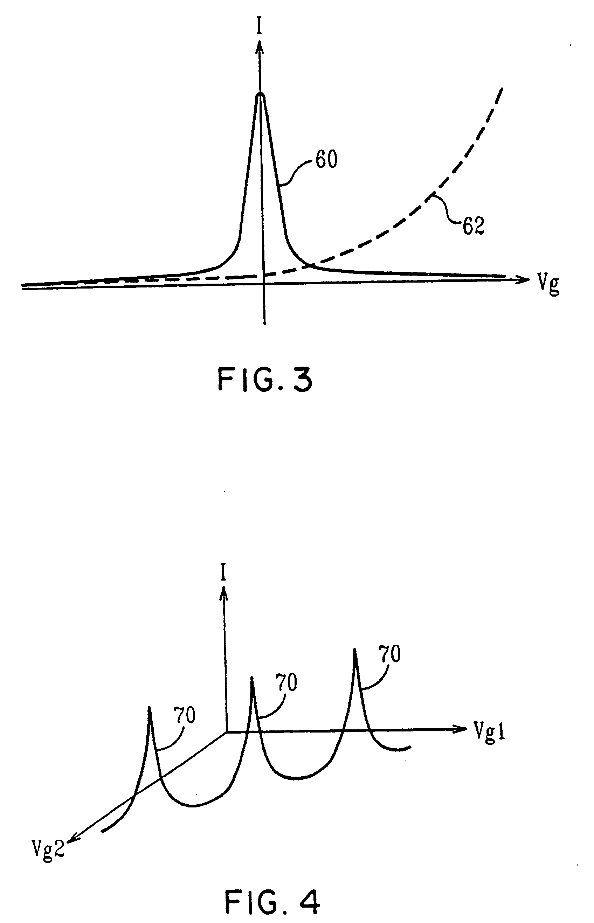

In addition, the inventive device 10 can be used as a frequency multiplier or in multilevel logic, based on the non-monotonic increase in current with the gate voltage. FIG 3 shows the nearly instantaneous large increase in current 60 when the inventive superconductor device 10 turns on. This is in contrast to the monotonic current increase 62 for a typical conductor.

Further, the inventive superconductor device can be used as a comparator between the voltages on the bottom and top gates 44, 43. Superconductivity, and hence high current, are achieved only at a specific combinations of gate voltages. This is shown in FIG 4, where large currents 70, indicating superconductivity, occur at particular values of top and bottom gate voltages, Vg1 and Vg2, respectively.

The invention can be implemented by growing Si/SiGe heterostructure layers 24, 32, where the electrons 25 exist in a Si-layer 24 under tensile strain, and the holes are in the SiGe layer 32 under compressive strain. These layers are separated by the thin SiGe barrier layer 30 (about 1 nm thick) with Ge content of approximately half that of the P channel 34. That is,the value of x in the Si₁₋ₓGeₓ material of the barrier layer 30 is approximately half the value of x in the Si₁-ₓGeₓ material of the P channel 34. Currents flow in opposite directions in those channels 24, 32 by passing successively through the external contacts 26, 28, 36, 34, for example.

## Claims

1. A structure for carrying superconducting current comprising:
a substrate;
a first epitaxial P type semiconductor layer (32) for transporting holes (33);
a third epitaxial N type semiconductor layer (24) for transporting electrons;
a second epitaxial barrier layer (30) separating said first and third layers, said barrier layer restricting the recombination of electrons (25) while permitting coulomb force attraction between electrons and said holes to form electron-hole pairs;
**characterised in that**
said first layer includes SiGe and wherein said first layer is under compressive strain; and
wherein said third layer includes Si and wherein said third layer is under tensile strain.

2. The structure of claim 1, wherein said second layer includes SiGe having a thickness in the range from about 0.5 to 3 nanometers.

3. The structure of claim 1, wherein said first layer includes Si₁₋ₓGeₓ, where x is in the range from about 0.6 to about 0.8.

4. The structure of claim 1, wherein said second layer includes Si₁₋ₓGeₓ, where x is in the range from about 0.3 to about 0.4.

5. The structure of claim 1, wherein said substrate includes a graded layer and a buffer layer formed between said graded layer and said third layer.

6. The structure of claim 5, wherein said graded layer includes Si1-yGey, where y is in the range from about 0 to about 0.3.

7. The structure of claim 5, wherein said buffer layer includes Si_{0.7}Ge_{0.3}.

8. The structure of claim 1 further including a fourth epitaxial barrier layer, and wherein said first through fourth layers are repeated.

9. The structure of claim 1 further comprising a bottom gate located below said substrate, and a top gate located above said third epitaxial N type semiconductor layer.

10. The structure of claim 8 wherein voltages on said top and bottom gates induce superconductivity.

11. The structure of claim 8 further comprising a top silicon layer formed between said top gate and said third epitaxial N type semiconductor layer.

12. The structure of claim 1 further comprising a light source for shining a light of predetermined wavelength to induce superconductivity.

13. The structure of claim 11, wherein said predetermined wavelength is in the range of approximately 1.0 µm to approximately 1.5 µm.

14. A field effect transistor for carrying superconducting current comprising the structure of claim 1.

15. The field effect transistor of claim 14 further including a gate electrode positioned adjacent one of said first and third layers and wherein said first and third layers are coupled together on one side of said gate electrode.

16. A comparator having a structure for carrying superconducting current as claimed in claims 1 to 13.

17. A magnetic detector having a structure for carrying superconducting current as claimed in claims 1 to 13.

18. A photo-detector having a structure for carrying superconducting current as claimed in claims 1 to 13.

19. The photo-detector of claim 18 further including a radiant energy source and a light path for directing radiant energy from said radiant energy source to said first and third layers.

20. A frequency multiplier having a structure for carrying superconducting current as claimed in claims 1 to 13.

## Patentansprüche

1. Struktur zur Supraleitung eines Stroms, wobei die Struktur Folgendes umfasst:
eine erste epitaxiale p-Halbleiterschicht (32) zum Leiten von Löchern (33);
eine dritte epitaxiale n-Halbleiterschicht (24) zum Leiten von Elektronen;
eine zweite epitaxiale Sperrschicht (30) zum Trennen der ersten von der zweiten Schicht, wobei die Sperrschicht die Rekombination von Elektronen (25) begrenzt und gleichzeitig die Coulombsche Anziehung zwischen Elektronen und den Löchern und damit die Bildung von Elektronen-Loch-Paaren zulässt;
**dadurch gekennzeichnet, dass**
die erste Schicht SiGe enthält und unter Druckspannung steht; und
die dritte Schicht Si enthält und unter Zugspannung steht.

2. Struktur nach Anspruch 1, bei welcher die zweite Schicht SiGe mit einer Schichtdicke im Bereich von etwa 0,5 bis 3 nm enthält.

3. Struktur nach Anspruch 1, bei welcher die erste Schicht Si₁₋ₓGeₓ enthält, wobei x im Bereich von etwa 0,6 bis etwa 0,8 liegt.

4. Struktur nach Anspruch 1, bei welcher die zweite Schicht Si₁₋ₓGeₓ enthält, wobei x im Bereich von etwa 0,3 bis etwa 0,4 liegt.

5. Struktur nach Anspruch 1, bei welcher das Substrat eine abgestufte Schicht und eine zwischen dieser abgestuften Schicht und der dritten Schicht gebildete Pufferschicht enthält.

6. Struktur nach Anspruch 5, bei welcher die abgestufte Schicht Si_{1-y}Ge_{y} enthält, wobei y im Bereich von etwa 0 bis etwa 0,3 liegt.

7. Struktur nach Anspruch 5, bei welcher die Pufferschicht Si_{0,7}Ge_{0,3} enthält.

8. Struktur nach Anspruch 1, welche ferner eine vierte epitaxiale Sperrschicht enthält und bei welcher sich die erste bis vierte Schicht wiederholen.

9. Struktur nach Anspruch 1, welche ferner eine unterhalb des Substrats gelegene unteres Gateelektrode und eine oberhalb der dritten epitaxialen n-Halbleiterschicht gelegene obere Gateelektrode umfasst.

10. Struktur nach Anspruch 8, bei welcher die an der oberen und an der unteren Gateelektrode anliegenden Spannungen Supraleitung erzeugen.

11. Struktur nach Anspruch 8, welche ferner eine zwischen der oberen Gateelektrode und der dritten epitaxialen n-Halbleiterschicht gebildete obere Siliciumschicht umfasst.

12. Struktur nach Anspruch 1, welche ferner eine Lichtquelle zum Bestrahlen mit einem Licht einer vorgegebene Wellenlänge umfasst, um die Supraleitung zu erzeugen.

13. Struktur nach Anspruch 11, bei welcher die vorgegebene Wellenlänge im Bereich von etwa 1,0 µm bis etwa 1,5 µm liegt.

14. Feldeffekttransistor zur Supraleitung eines Stroms, welcher die Struktur nach Anspruch 1 umfasst.

15. Feldeffekttransistor nach Anspruch 14, welcher ferner eine unmittelbar neben der ersten bzw. der dritten Schicht gelegene Gateelektrode enthält und bei welchem die erste und die dritte Schicht an einer Seite der Gateelektrode miteinander verbunden sind.

16. Komparator mit einer Struktur zur Supraleitung eines Stroms nach den Ansprüchen 1 bis 13.

17. Magnetfelddetektor mit einer Struktur zur Supraleitung eines Stroms nach den Ansprüchen 1 bis 13.

18. Photodetektor mit einer Struktur zur Supraleitung eines Stroms nach den Ansprüchen 1 bis 13.

19. Photodetektor nach Anspruch 18, welcher ferner eine Strahlungsquelle und einen Strahlengang zum Leiten der Strahlungsenergie von der Strahlungsquelle zur ersten und dritten Schicht enthält.

20. Frequenzvervielfacher mit einer Struktur zur Supraleitung eines Stroms nach den Ansprüchen 1 bis 13.

## Revendications

1. Une structure pour transporter un courant de supraconduction, comprenant :
un substrat ;
une première couche de semi-conducteur de type P (32) épitaxiale, pour transporter des trous (33) ;
une troisième couche de semi-conducteur de type N (24) épitaxiale, pour transporter des électrons ;
une deuxième couche formant barrière (30) épitaxiale, séparant lesdites première et troisième couches, ladite couche formant barrière restreignant la recombinaison des électrons (25), tout en permettant qu'agisse une attraction par une force de Coulomb entre des électrons et lesdits trous, pour former des paires électrons-trous ;
ladite première couche comprend du SiGe et dans laquelle ladite première couche est placée sous l'effet d'une contrainte de compression ; et
dans laquelle ladite troisième couche comprend du Si et dans laquelle ladite troisième couche est placée sous l'effet d'une contrainte de traction.

2. La structure selon la revendication 1, dans laquelle ladite deuxième couche comprend du SiGe, d'une épaisseur dans la plage d'environ 0,5 à 3 nanomètres.

3. La structure selon la revendication 1, dans laquelle ladite première couche comprend du Si₁₋ₓGeₓ, x étant dans la plage d'environ 0,6 à environ 0,8.

4. La structure selon la revendication 1, dans laquelle ladite deuxième couche comprend du Si₁₋ₓGeₓ, x étant dans la plage d'environ 0,3 à environ 0,4.

5. La structure selon la revendication 1, dans laquelle ledit substrat comprend une couche à gradient et une couche tampon, formée entre ladite couche calibrée et ladite troisième couche.

6. La structure selon la revendication 5, dans laquelle ladite couche calibrée comprend du Si_{1-y}Ge_{y}, dans laquelle y est dans la plage de 0 à environ 0,3.

7. La structure selon la revendication 5, dans laquelle ladite couche tampon comprend du Si_{0.7}Ge_{0.3}.

8. La structure selon la revendication 1, comprenant en outre une quatrième couche formant barrière épitaxiale et dans laquelle lesdites première à quatrième couches sont répétées.

9. La structure selon la revendication 1, comprenant en outre une grille inférieure placée au-dessous dudit substrat, et une grille supérieure placée au-dessus de ladite troisième couche à semi-conducteur de type N épitaxiale.

10. La structure selon la revendication 8, dans laquelle des tensions, appliquées sur lesdites grilles supérieure et inférieure, induisent une supraconductivité.

11. La structure selon la revendication 8, comprenant en outre une couche supérieure en silicium formée entre ladite grille supérieure et ladite troisième couche à semi-conducteur de type N épitaxiale.

12. La structure selon la revendication 1, comprenant en outre une source lumineuse, pour émettre une lumière de longueur d'onde prédéterminée, pour induire une supraconductivité.

13. La structure selon la revendication 11, dans laquelle ladite longueur d'onde prédéterminée est dans la plage d'environ 1,0 µm à environ 1,5 µm.

14. Un transistor à effet de champ pour transporter un courant de supraconductivité, présentant la structure selon la revendication 1.

15. Le transistor à effet de champ selon la revendication 14, comprenant en outre une électrode de grille, pour positionner de façon adjacente à l'une desdites première et troisième couches, et dans lequel lesdites première et troisième couches sont couplées ensemble sur un côté de ladite électrode de grille.

16. Un comparateur, ayant une structure pour transporter un courant de supraconductivité selon les revendications 1 à 13.

17. Un détecteur magnétique, ayant une structure pour transporter un courant de supraconductivité, tel qu'indiqué aux revendications 1 à 13.

18. Un photo-détecteur, ayant une structure pour transporter un courant de supraconductivité selon l'une des revendications 1 à 13.

19. Le photo-détecteur selon la revendication 18, comprenant en outre une source d'énergie de rayonnement et un chemin de lumière pour diriger l'énergie de rayonnement, de ladite source d'énergie de rayonnement vers lesdites première et troisième couches.

20. Un multiplicateur de fréquences, ayant une structure pour transporter un courant de supraconductivité, tel qu'indiqué aux revendications 1 à 13.
